# EUROPÄISCHE PATENTSCHRIFT

(11) **EP 0 632 595 B1**
(45) Veröffentlichungstag und Bekanntmachung des Hinweises auf die Patenterteilung: **20.01.1999**
(21) Anmeldenummer: 94109104.3
(22) Anmeldetag: 14.06.1994
(51) Int. Cl.: H03K 19/0175, H03K 19/018, H03K 19/086

(54) **Leitungstreiberschaltstufe in Stromschaltertechnik**
Line-driver-stage in current switch technology
Circuit d'attaque de haute capacité dans une technique pour commutateurs

(30) Priorität: 28.06.1993 DE 4321483
(43) Veröffentlichungstag der Anmeldung: 04.01.1995
(73) Patentinhaber: SIEMENS AKTIENGESELLSCHAFT, 80333 München (DE)
(72) Erfinder: Wilhelm, Wilhelm, Dr. Ing., D-81477 München (DE)

(56) Entgegenhaltungen:
- EP-A- 0 173 288
- EP-A- 0 314 139
- EP-A- 0 423 940
- EP-A- 0 432 577
- FR-A- 2 599 911
- US-A- 5 012 137
- US-A- 5 041 743
- US-A- 5 122 683
- U. Tietze, Ch. Schenk, "Halbleiter-Schaltungstechnik", 6. Auflage,Springer-Verlag, Berlin, Heidelberg, 1983, Seite 204

## Beschreibung

Die Erfindung betrifft eine Schaltstufe mit den Merkmalen:
(a) ein Differenzverstärker weist einen ersten und einen zweiten Verstärkerzweig auf,
(b) der erste Verstärkerzweig enthält einen Widerstand,
(c) ein erster Anschluß des Widerstands ist ein Anschluß für Bezugspotential,
(d) ein zweiter Anschluß des Widerstandes ist über die Basis-Emitter-Strecke eines Emitterfolgertransistors mit einem Ausgangsanschluß der Leitungstreiberschaltstufe verbunden,
(e) der zweite Verstärkerzweig ist mit einem ersten Anschluß eines Sättigungsverhinderungselementes verbunden,
(f) der zweite Anschluß des Sättigungsverhinderungselementes ist mit dem Ausgangsanschluß verbunden,
(g) der erste Anschluß des Sättigungsverhinderungselementes ist über die Basis-Emitter-Strecke eines Bipolartransistors mit einem Anschluß für ein Versorgungspotential verbunden,
(h) der Kollektor des Bipolartransistors ist mit dem Emitter des Emitterfolgertransistors verbunden.

Eine solche Schaltung ist in der FR-A-2 599 911 gezeigt.

Eine andere Schaltstufe, umfassend einen Differenzverstärker mit einem Widerstand in einem der Verstärkerzweige, der über einen Emitterfolgertransistor an einen Ausgangsanschluß gekoppelt ist, ist in der Literaturstelle George R. Watson, "Advances in Bipolar VLSI", Proceedings of the IEEE, Band 78, Nr. 11, November 1990 gezeigt. Üblicherweise ist der Ausgang der Schaltstufe mit einer auf einer Leiterplatte angeordneten Leitung verbunden. Der Wellenwiderstand der Leitung beträgt standardgemäß 50 Ohm. Die Leitung ist am Ende mit dem Wellenwiderstand abgeschlossen. Um die Leitung auf einem H-Pegel zu halten, der für ein Bezugspotential von 0V üblicherweise bei -0,9V liegt, fließt ein statischer Strom von 22mA über den Emitterfolgertransistor, die Leitung und den Abschlußwiderstand. Dieser Strom bedingt unter Berücksichtigung einer endlichen Stromverstärkung des Emitterfolgertransistors einen Maximalwert für den Arbeitswiderstand im Differenzverstärkerzweig (200 Ohm). Bei einem L-Pegel, der üblicherweise bei -1,7V liegt, fließt der Schaltstrom des Differenzverstärkers durch den Arbeitswiderstand, so daß daran der Pegelhub von 0,8V abfällt. Somit wird bei Berücksichtigung des Maximalwertes des Arbeitswiderstandes ein Minimalwert von 4mA für den Schaltstrom festgelegt. Der Schaltstrom und der durch den Emitterfolger fließende Strom ergeben eine relativ hohe Verlustleistung.

Es ist die Aufgabe der Erfindung, eine Leitungstreiberschaltstufe in Stromschaltertechni anzugeben, mit der ein temperaturkompensierter Ausgangspegel bei geringer Verlustleistung zu erhalten ist.

Dies wird dadurch gelöst, daß je eine Kompensationsstromquelle mit positivem Temperaturkoeffizienten zwischen die Basisanschlüsse des Emitterfolgertransistors und des Bipolartransistors und einen Anschluß für ein weiteres Versorgungspotential geschaltet ist.

Vorteilhafte Weiterbildungen und Ausführungsformen sind Gegenstand der abhängigen Ansprüche.

Im folgenden wird die Erfindung anhand der in der Zeichnung dargestellten Figuren näher erläutert. Es zeigen:
- Figur 1: eine Leitungstreiberschaltstufe,
- Figur 2: eine Ausführungsform der Leitungsanpassung,
- Figur 3: eine Ausführungsform für temperaturkompensierte Ausgangspegel, und
- Figur 4: eine Ausführungsform für eingangsseitig angepaßte Leitungen.

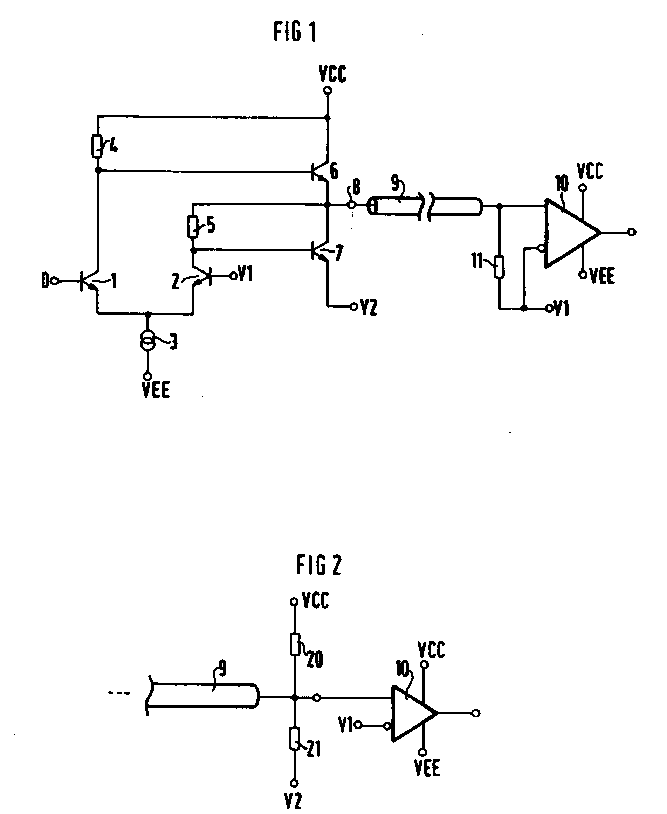

Die Leitungstreiberschaltstufe der Figur 1 enthält einen Differenzverstärker mit zwei Differenzverstärkerzweigen, die von einer Stromquelle 3 gespeist werden. Die Verstärkerzweige enthalten je einen Schalttransistor 1 bzw. 2. Der Transistor 1 wird von einem Datensignal D gesteuert, die Basis des Transistors 2 ist an ein Referenzpotential V1 angeschlossen, das in der Mitte des Eingangssignalpegelhubs liegt. Üblicherweise hat das Referenzpotential V1 einen Wert von etwa -1,33V. Die Kollektoren der Transistoren 1, 2 sind mit den Basisanschlüssen von zwei mit ihren Kollektor-Emitter-Strecken in Reihe geschalteten Bipolartransistoren 6, 7 verbunden. Der Verbindungspunkt der Transistoren 6, 7 ist ein Ausgangsanschluß 8. Der Kollektor des Transistors 6 ist mit einem Bezugspotential VCC (Masse) verbunden, der Emitter des Transistors 7 mit einem Versorgungspotential V2. Die Spannung zwischen den Potentialen V2 und VCC beträgt beispielsweise das Doppelte der Spannung zwischen den Potentialen V1 und VCC, also -2,66V. Der erste Verstärkerzweig enthält einen Arbeitswiderstand 4, der zwischen der Basis des Transistors 6 und dem Bezugspotential VCC liegt. Zwischen Basis und Kollektor des Transistors 7 ist ein weiterer Widerstand 5 geschaltet, der der Sättigungsverhinderung des Transistors 7 dient. Die Widerstände 4, 5 haben vorzugsweise die gleichen Widerstandswerte.

Der Ausgangsanschluß 8 ist beispielsweise mit einem Ausgangspad einer integrierten Schaltung verbunden. Das Ausgangspad ist über eine etwa auf einer gedruckten Leiterplatte angeordnete Leitung 9 mit einer Eingangsstufe 10 einer weiteren integrierten Schaltung verbunden. Am Leitungsende wird die Leitung 9 mit ihrem Wellenwiderstand 11 abgeschlossen. Für übliche Leiterplatten betragen der Wellenwiderstand der Leitung 9 und der Wert des Abschlußwiderstandes 11 etwa 50 Ohm. Der Abschlußwiderstand 11 ist an das Referenzpotential V1 angeschlossen. Das Referenzpotential V1 speist auch einen Referenztransistor des Differenzverstärkers der Eingangsstufe 10.

Die Schaltung arbeitet folgendermaßen: Liegt das Eingangssignal D auf einem H-Pegel, ist der Transistor 1 leitend, der Transistor 2 gesperrt. Der Schaltstrom der Stromquelle 3 fließt dann über den Widerstand 4, der derart bemessen ist, daß an ihm eine Spannung gleich dem Signalpegelhub von 0,8V abfällt. Der Transistor 6 wirkt als Emitterfolgertransistor, so daß der Ausgangsanschluß 8 auf etwa -1,7V liegt. Es fließt nun ein statischer Strom vom Potential V1 über Abschlußwiderstand 11, Leitung 9 und Transistor 7 zum Potential V2. Der Strom stellt sich dabei auf 7,5mA ein. Wenn das Eingangssignal D ein L-Pegel ist, ist der Transistor 1 gesperrt, der Transistor 2 leitend. Der Schaltstrom der Stromquelle 3 fließt dann über Emitterfolgertransistor 6, Widerstand 5 und Transistor 2. Der Spannungsabfall am Widerstand 5 sorgt dafür, daß der Transistor 7 gesperrt ist und somit ein statischer Strom vom Bezugspotential VCC über Emitterfolgertransistor 6, Leitung 9 und Abschlußwiderstand 11 zum Potential V1 fließt. Der Strom beträgt etwa 7,5 mA. Der H-Pegel am Ausgang 8 stellt sich auf -0,9V ein.

Der bei einem H- und einem L-Pegel am Ausgang 8 durch die Transistoren 6 bzw. 7 fließende Strom ist in beiden Schaltzuständen etwa 7,5 mA. Er beträgt also nur ein Drittel des Maximalstromes bei der eingangs in der Literaturstelle von George R. Watson genannten Schaltstufe. Folglich liegen die Basisströme der Transistoren 6, 7 nur bei einem Drittel des bisher erforderlichen Wertes. Somit können die Widerstandswerte der Widerstände 4, 5 erhöht werden, gleichzeitig kann der Schaltstrom der Stromquelle 3 auf ein Drittel verringert werden. Insgesamt ergibt sich eine wesentlich verringerte, etwa um zwei Drittel reduzierte Verlustleistung.

Alternativ zu dem in der Figur 1 gezeigten angepaßten Abschluß der Leitung 9 kann auch eine Anpassung gemäß der Ausführungsform nach Figur 2 verwendet werden. Die Leitung 9 ist sowohl zum Bezugspotential VCC als auch zum Versorgungspotential V2 hin mit je einem Widerstand 20 bzw. 21 abgeschlossen. Die Widerstände 20, 21 haben einen im Vergleich zum Widerstand 11 der Figur 1 doppelten Widerstandswert. Die in den Figuren 1, 2 gezeigten Anpassungsschaltungen sind beide elektrisch gleichwertig. Der Vorteil der Schaltung der Figur 2 liegt darin, daß die Versorgung der Leitung mit dem Versorgungspotential V2 und die Versorgung der Eingangsstufe mit dem Referenzpotential V1 voneinander getrennt sind. Dadurch wirken Belastungsschwankungen im Versorgungskreis für das Potential V2 nicht auf den Versorgungskreis für das Potential V1 ein. Da vom Versorgungspotential V1 nur die Basisströme der Referenztransistoren getrieben werden, kann es beispielsweise durch einfache Spannungsteilung vorteilhafterweise mit hochohmigen Widerständen aus den Versorgungspotentialen VCC, VEE erzeugt werden.

Die in der Figur 1 gezeigte Leitungstreiberschaltstufe erzeugt Ausgangspegel mit positivem Temperaturkoeffizienten. Dies bedeutet, daß die Signalpegel mit zunehmender Temperatur ansteigen. Dies rührt daher, daß der Spannungsabfall an einem pn-Übergang, also auch der Basis-Emitter-Strecke eines Bipolartransistors, mit steigender Temperatur abnimmt. Die temperaturabhängigen Signalpegel bei diesen Schaltstufen entsprechen dem sogenannten 10k-Industriestandard.

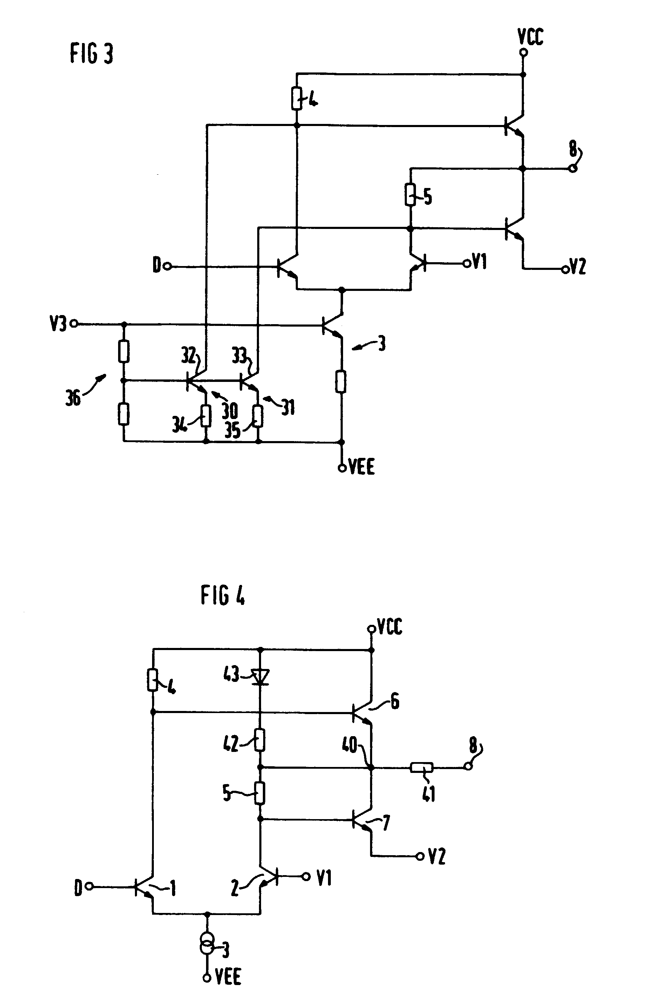

Um temperaturkompensierte Ausgangspegel (100k-Standard) zu erhalten, werden gemäß der Figur 3 an den Widerständen 4, 5 Kompensationsströme eingespeist. Diese werden von je einer Kompensationsstromquelle 30, 31 erzeugt, die jeweils zwischen einen der Widerstände 4, 5 und das Versorgungspotential VEE geschaltet sind. Dabei erzeugen die Kompensationsstromquellen 30, 31 jeweils einen temperaturabhängigen Strom mit positivem Temperaturkoeffizienten, der zusätzlich zum Strom der Stromquelle 3 durch die Widerstände 4 bzw. 5 fließt. Die Kompensationsströme erzeugen an den Widerständen 4, bzw. 5 einen Spannungsabfall, mit dem der Temperaturgang der Ausgangssignalpegel am Ausgang 8 ausgeglichen wird.

In einer bevorzugten Ausführungsform sind die Kompensationsstromquellen 30, 31 aus je einem Bipolartransistor 32 bzw. 33 mit emitterseitigem Widerstand 34 bzw. 35 aufgebaut. Die Basisanschlüsse der Transistoren 32, 33 sind gemeinsam mit dem Mittelausgang eines ohmschen Spannungsteilers 36 verbunden. Der Spannungsteiler ist zwischen ein Referenzpotential V3 und das Versorgungspotential VEE geschaltet. Das Referenzpotential V3 weist einen negativen Temperaturkoeffizienten auf, der betragsmäßig dem Temperaturkoeffizienten eines pn-Übergangs entspricht. Durch das Referenzpotential V3 wird auch die aus einem Bipolartransistor und einem emitterseitigen Widerstand aufgebaute Schaltstromquelle 3 angesteuert. Dadurch ist der von der Stromquelle 3 eingeprägte Strom temperaturkompensiert.

Die am Mittelabgriff des Spannungsteilers 36 bezüglich des Versorgungspotentials VEE anliegende Spannung hat dann einen entsprechend dem Teilungsverhältnis des Spannungsteilers verringerten negativen Temperaturkoeffizienten. Im Zusammenhang mit dem Temperaturgang der Basis-Emitter-Spannung der Transistoren 32, 33 ergibt sich ein von diesen Stromquellen 30, 31 eingeprägter Strom mit einem positiven Temperaturkoeffizienten. Bei einem Spannungsteilungsverhältnis von 1:2 des Spannungsteilers 36 ergeben sich Kompensationsströme, mit denen der Temperaturgang der Ausgangssignalpegel am Ausgang 8 ausgeglichen wird.

Anstelle der Leitungsanpassung am Leitungsende gemäß der Figuren 1 und 2 kann auch eine Anpassung am Leitungsanfang gemäß der Figur 4 erfolgen. Hierzu ist zwischen den Ausgangsanschluß 8 und den Verbindungspunkt 40 des Emitters des Emitterfolgertransistors 6 mit dem Kollektor des Transistors 7 ein Widerstand 41 geschaltet. Der Widerstand 41 ist derart bemessen, daß sich zusammen mit dem am Knoten 40 wirksamen Ausgangswiderstand der Schaltstufe in etwa der Wellenwiderstand der am Ausgang 8 angeschlossenen Leitung ergibt.

Zwischen dem Knoten 40 und Versorgungspotential VCC ist zusätzlich die Reihenschaltung aus einer Diodenstrecke 43 und einem Widerstand 42 geschaltet. Vorteilhafterweise weisen die Widerstände 4, 5, 42 jeweils den gleichen Widerstandswert auf. Bei einem H-Pegel für das Eingangssignal D fließt der Strom der Stromquelle 3 über den Widerstand 4. Außerdem ist ein leitender Strompfad zwischen die Potentiale VCC, V2 geschaltet, der die Diode 43, den Widerstand 42, den Knoten 40 und den Bipolartransistor 7 umfaßt. Aufgrund des symmetrischen Aufbaus der Schaltstufe ergibt sich, daß in diesem Fall die Spannung an den Widerständen 4 und 42 gleich groß ist. Somit ist der letztgenannte Strom zwischen den Potentialen VCC, V2 gleich groß dem Strom der Stromquelle 3. Im Ruhezustand fließt nun über den Widerstand 41 und die am Ausgang 8 angeschlossene Leitung kein statischer Strom. Wenn das Eingangssignal D ein L-Pegel ist, fließt der Strom der Stromquelle 3 über den Strompfad, der aus Emitterfolgertransistor 6, Knoten 40, Widerstand 5 und Schalttransistor 2 gebildet wird. Der Transistor 7 ist dabei gesperrt. Auch in diesem Falle fließt durch den Widerstand 41 im Ruhezustand kein Strom. Die Leitungstreiberschaltstufe der Figur 4 hat demnach den Vorteil einer äußerst geringen statischen Verlustleistung, die etwa ein Fünftel der Verlustleistung des aus der Literaturstelle George R. Watson bekannten Leitungstreibers beträgt.

## Patentansprüche

1. Leitungstreiberschaltstufe mit den Merkmalen:
(a) ein Differenzverstärker weist einen ersten und einen zweiten Verstärkerzweig auf,
(b) der erste Verstärkerzweig enthält einen Widerstand (4),
(c) ein erster Anschluß des Widerstandes (4) ist ein Anschluß für Bezugspotential (VCC),
(d) ein zweiter Anschluß des Widerstandes (4) ist über die Basis-Emitter-Strecke eines Emitterfolgertransistors (6) mit einem Ausgangsanschluß (8) der Leitungstreiberschaltstufe verbunden,
(e) der zweite Verstärkerzweig ist mit einem ersten Anschluß eines Sättigungsverhinderungselementes (5) verbunden,
(f) der zweite Anschluß des Sättigungsverhinderungselementes (5) ist mit dem Ausgangsanschluß (8) verbunden,
(g) der erste Anschluß des Sättigungsverhinderungselementes (5) ist über die Basis-Emitter-Strecke eines Bipolartransistors (7) mit einem Anschluß für ein Versorgungspotential (V2) verbunden,
(h) der Kollektor des Bipolartransistors (7) ist mit dem Emitter des Emitterfolgertransistors (6) verbunden,
**dadurch gekennzeichnet**, daß
(i) je eine Kompensationsstromquelle (30, 31) mit positivem Temperaturkoeffizienten zwischen die Basisanschlüsse des Emitterfolgertransistors (6) und des Bipolartransistors (7) und einen Anschluß für ein weiteres Versorgungspotential (VEE) geschaltet ist.

2. Leitungstreiberschaltstufe nach Anspruch 1,
**dadurch gekennzeichnet**, daß
das Sättigungsverhinderungselement (5) ein Widerstand ist.

3. Leitungstreiberschaltstufe nach Anspruch 1 oder 2,
**dadurch gekennzeichnet,** daß
zwischen den vom Emitter des Emitterfolgertransistors (6) und dem Kollektor des Bipolartransistors (7) gebildeten Verbindungsknoten (4) und den Ausgangsanschluß (8) ein Widerstand (41) geschaltet ist, und daß zwischen den ersten Anschluß des Sättigungsverhinderungselementes (5) und den Anschluß für das Bezugspotential (VCC) die Reihenschaltung aus einer Diode (43) und einem Widerstand (42) geschaltet ist.

4. Leitungstreiberschaltstufe nach einem der Ansprüche 1 bis
3, **dadurch gekennzeichnet,** daß
ein Spannungsteiler zwischen einen Anschluß für ein Referenzpotential (V3) mit negativem Temperaturkoeffizienten, der betragsmäßig dem Temperaturkoeffizienten einer Basis-Emitter-Strecke eines Bipolartransistors entspricht, und das weitere Versorgungspotential (VEE) geschaltet ist, daß die Kompensationsstromquellen (30, 31) jeweils aus einem Bipolartransistor mit emitterseitigem Widerstand bestehen und daß die Basisanschlüsse der Bipolartransistoren mit einem Mittelanschluß des Spannungsteilers verbunden sind.

## Claims

1. Line driver switching stage having the features:
(a) a differential amplifier has a first and a second amplifier path,
(b) the first amplifier path contains a resistor (4),
(c) a first terminal of the resistor (4) is a terminal for reference-earth potential (VCC),
(d) a second terminal of the resistor (4) is connected to an output terminal (8) of the line driver switching stage via the base-emitter junction of an emitter-follower transistor (6),
(e) the second amplifier path is connected to a first terminal of a saturation prevention element (5),
(f) the second terminal of the saturation prevention element (5) is connected to the output terminal (8),
(g) the first terminal of the saturation prevention element (5) is connected to a terminal for a supply potential (V2) via the base-emitter junction of a bipolar transistor (7),
(h) the collector of the bipolar transistor (7) is connected to the emitter of the emitter-follower transistor (6),
characterized in that
(i) a respective compensation current source (30, 31) with positive temperature coefficient is connected between the base terminals of the emitter-follower transistor (6) and of the bipolar transistor (7) and a terminal for a further supply potential (VEE).

2. Line driver switching stage according to Claim 1,
characterized in that the saturation prevention element (5) is a resistor.

3. Line driver switching stage according to Claim 1 or 2,
characterized in that a resistor (41) is connected beween the output terminal (8) and the connecting node (4) formed by the emitter of the emitter-follower transistor (6) and the collector of the bipolar transistor (7), and in that the series circuit formed by a diode (43) and a resistor (42) is connected between the first terminal of the saturation prevention element (5) and the terminal for the reference-earth potential (VCC).

4. Line driver switching stage according to one of Claims 1 to 3,
characterized in that a voltage divider is connected between a terminal for a reference potential (V3) with negative temperature coefficient, the magnitude of which corresponds to the temperature coefficient of a base-emitter junction of a bipolar transistor, and the further supply potential (VEE), in that the compensation current sources (30, 31) each comprise a bipolar transistor with an emitter-side resistor, and in that the base terminals of the bipolar transistors are connected to a centre terminal of the voltage divider.

## Revendications

1. Circuit de commande de ligne possédant les caractéristiques suivantes:
(a) un amplificateur différentiel comprend une première et une seconde branches d'amplificateur,
(b) la première branche d'amplificateur contient une résistance (4),
(c) une première borne de la résistance (4) est une borne pour un potentiel de référence (VCC),
(d) une seconde borne de la résistance (4) est reliée à une borne de sortie (8) du circuit de commande de ligne par le biais du trajet base-émetteur d'un transistor émetteur-suiveur (6),
(e) la seconde branche d'amplificateur est reliée à une première borne d'un élément empêchant la saturation (5),
(f) la seconde borne de l'élément empêchant la saturation (5) est reliée à la borne de sortie (8),
(g) la première borne de l'élément empêchant la saturation (5) est reliée à une borne pour un potentiel d'alimentation (V2) par le biais du trajet base-émetteur d'un transistor bipolaire (7),
(h) le collecteur du transistor bipolaire (7) est relié à l'émetteur du transistor émetteur-suiveur (6),
caractérisé en ce que
(i) une source de courant de compensation (30, 31) à coefficient de température positif est branchée, à chaque fois, entre les bornes de base du transistor émetteur-suiveur (6) et du transistor bipolaire (7) et une borne pour un autre potentiel d'alimentation (VEE).

2. Circuit de commande de ligne selon la revendication 1, caractérisé en ce que l'élément empêchant la saturation (5) est une résistance.

3. Circuit de commande de ligne selon la revendication 1 ou 2, caractérisé en ce qu'une résistance (41) est branchée entre le noeud (40) formé par l'émetteur du transistor émetteur-suiveur (6) et le collecteur du transistor bipolaire (7) et la borne de sortie (8), et en ce que le montage en série-formé par une diode (43) et une résistance (42) est branché entre la première borne de l'élément empêchant la saturation (5) et la borne pour le potentiel de référence (VCC).

4. Circuit de commande de ligne selon l'une des revendications 1 à 3, caractérisé en ce qu'un diviseur de tension est branché entre une borne pour un potentiel de référence (V3) ayant un coefficient de température négatif dont la valeur correspond au coefficient de température d'un trajet base-émetteur d'un transistor bipolaire, et l'autre potentiel d'alimentation (VEE), en ce que les sources de courant de compensation (30, 31) sont formées, à chaque fois, par un transistor bipolaire avec une résistance sur le côté de l'émetteur, et en ce que les bornes de base des transistors bipolaires sont reliées à une borne médiane du diviseur de tension.
